# EUROPÄISCHE PATENTSCHRIFT

(11) **EP 1 926 143 B1**
(45) Veröffentlichungstag und Bekanntmachung des Hinweises auf die Patenterteilung: **15.07.2009**
(21) Anmeldenummer: 07019114.3
(22) Anmeldetag: 28.09.2007
(51) Int. Cl.: H01L 23/473

(54) **Kühlkörper für Halbleiterbauelemente oder dergleichen Wärmequellen sowie Verfahren zu dessen Herstellung**
Cooling unit for semi-conductor components or similar heat sources and method for its manufacture
Corps de refroidissement pour composants semi-conducteurs ou sources de chaleur analogues ainsi que son procédé de fabrication

(30) Priorität: 22.11.2006 DE 102006054939; 24.11.2006 DE 102006055455
(43) Veröffentlichungstag der Anmeldung: 28.05.2008
(73) Patentinhaber: Alcan Technology & Management AG, 8212 Neuhausen (CH)
(72) Erfinder: Bock, Stephan, 78224 Singen/Friedingen (DE); Brusberg, Lothar, 78224 Singen (DE)
(74) Vertreter: Hiebsch, Gerhard F.

(56) Entgegenhaltungen:
- EP-A- 0 798 954
- US-A1- 2004 069 451
- US-A1- 2006 231 236

## Beschreibung

Die Erfindung betrifft einen Kühlkörper für Halbleiterbauelemente oder dgl. Wärmequellen mit in Abstand zueinander von einem stranggepressten Grundkörper aufragenden Profilstreifen nach dem Oberbegriff des unabhängigen Patentanspruches. Zudem erfasst, die Erfindung ein Verfahren zum Herstellen eines solchen Kühlkörpers durch Strangpressen.

Kühlkörper dieser Art sind der US 2006/0231236 A1 zu entnehmen. Darin wird eine Profileinheit gezeigt, deren Grundkörper mehrere parallele Rinnen U-artigen Querschnittes aufweist, zwischen denen jeweils eine Profilwand verläuft. Dieser ist kopfseitig eine teilkreisförmige Rinne eines Verschlussprofils zugeordnet, die in Abstand zur Kopfhöhe seiner streifenförmigen Profilwand verläuft und weder letztere noch die Rinne verschließt.

Nach der Lehre der DE 35 18 310 A1 werden stranggepresste Vollprofile mit seitlichen Ausformungen als Kühlrippen für den Kühlkörper in die Einsatznuten der gesondert erzeugten Sockelplatte formschlüssig eingesetzt. Die Nutwände der Einsatznut werden nach dem Einbringen der Kühlrippe durch ein -- zwischen zwei Kühlrippen einfahrbares -- keilartig ausgebildetes Werkzeug verformt, das dazu in eine Hilfsnut V-förmigen Querschnitts eingesetzt wird und teilweise den Werkstoff des Gehäusesockels in Parallelnuten der Kühlrippe drückt.

Die DE 25 02 472 A1 zeigt an einem Kühlkörper für Thyristoren sich konisch zum Nutengrund hin verjüngende Einsatznuten der Basisgehäuseplatte für die Kühlrippen. Diese werden mit Übermaß in die -- mit Längsnuten in den beiden Seitenwänden versehenen -- Einsatznuten eingepresst. Während in diesem Falle eine Mindestdicke der Rippe erforderlich ist, um die notwendigen Druckkräfte beim Fügeverfahren aufnehmen zu können, ist bei einem Verfahren nach DE 35 18 310 A1 nur ein formschlüssiger Verbund erreichbar. In beiden Fällen ist die einsetzbare Rippenzahl -- und damit die erreichbare Wärme abführende Oberfläche -- einerseits durch die erforderliche Mindestdicke der Kühlrippen sowie andererseits durch die notwendige Mindestbreite der Zwischennuten begrenzt.

Um eine bessere Kühlleistung zu erreichen, werden häufig Kühlkörper aus separat gefertigten Rippen und Basisteilen zusammengefügt. In der Regel werden hierfür artgleiche Werkstoffe wie Aluminium und seine Legierungen verwendet. Die Rippen werden durch spezielle Fügeverfahren der Basis- oder Sockelplatte verbunden. Aus den verschiedensten technischen Gründen bestehen Zwänge, Kühlkörper dieser Art "in die Höhe" zu bauen. Dies führt jedoch zu einer wärmetechnisch geringen Effektivität, bedingt durch einen relativ schlechten Rippenwirkungsgrad; eine große Rippenhöhe ist auch nicht -- wegen der dann zu reduzierenden Rippenanzahl -- über eine vergrößerte Rippendicke zu kompensieren.

In Kenntnis dieser Gegebenheiten hat sich der Erfinder das Ziel gesetzt, eine neue Kühlplattengeometrie zu schaffen, durch die ein effektiverer Wärmehaushalt erreicht wird. Zudem soll dazu das Herstellungsverfahren für den Kühlkörper vereinfacht werden.

Zur Lösung dieser Aufgabe führt die Lehre des unabhängigen Anspruches; die Unteransprüche geben günstige Weiterbildengen an. Zudem fallen in den Rahmen der Erfindung alle Kombinationen aus zumindest zwei der in der Beschreibung, der Zeichnung und/oder den Ansprüchen offenbarten Merkmale.

Erfindungsgemäß ist zwischen den Rinnen des Verschlussprofils jeweils zumindest eine weitere Einformung vorgesehen, der in Verbundlage zumindest eine nutartige Einformung des aus einer Aluminiumlegierung bestehenden Grundkörpers angrenzend gegenüberliegt sowie mit ihr den Querschnitt einer kanalartigen Hohlkammer bestimmt. Letzterer soll in einer besonderen Ausgestaltung von i. w. dreiecksförmigem Querschnitt sein. Erfindungsgemäß sind die Innenflächen der Einformung mit einer querschnittlichen Zahnung versehen; dieser wellenartige Verlauf der Innenflächen erhöht deren. Oberfläche erheblich. Auch ist vorgesehen, dass die Wandung der kanalartigen Hohlkammer entsprechend mit einer querschnittlichen Zahnung versehen ist.

Nach einem weiteren Merkmal der Erfindung enthält die Einformung des Verschlussprofils in Querschnittsmitte einen Profilstreifen; diese Profilstreifen des Verschlussprofils verlaufen in dessen Längsrichtung parallel zueinander und zu den Seitenflächen des Verschlussprofils.

Als günstig hat es sich erwiesen, dass von den seitlichen Innenflächen der Rinnen des Verschlussprofils Zahnstreifen -- bevorzugt jeweils zumindest zwei Zahnstreifen -- abragen, wobei die Zahnstreifen der einen Innenfläche der Rinne i. w. rechteckigen Querschnitts den Zahnstreifen der anderen Innenfläche gegenüberliegen sollen. Diese Zahnstreifen dienen als Befestigungselemente; sie greifen in die Seitenflächen der Profilstäbe des Grundkörpers ein, welche beim Zusammenbau in jene Rinnen eingeschoben werden.

Im Rahmen der Erfindung liegt auch das Erzeugen einer Welle; in dem Zwischenraum zwischen zwei Profilstreifen verläuft zumindest ein Steg des Grundkörpers, der zum Erzeugen jener Wellung im Grundkörper oder im Verschlussprofil ausgebildet ist.

Auch hat es sich als günstig erwiesen, im Randstreifen an seiner Innenfläche in Abstand zur Bodenplatte des Grundkörpers parallel zu dieser in Längsrichtung eine Stufung als Anschlagelement für das Verschlussprofil anzuordnen bzw. anzuformen. Auch soll der Profilstreifen des Grundkörpers beidseits mit einem stufenartig vorstehenden Kantenstreifen als Anschlagelement für das Verschlussprofil versehen sein. Jene Stufungen der Randstreifen des Grundkörpers bestimmen dabei eine gemeinsame Ebene für die Kantenstreifen der Profilstreifen, die also miteinander fluchten.

Nach einem anderen Merkmal der Erfindung entsprechen zum einen der Abstand der Stufung von der Unterfläche der Bodenplatte und zum anderen die Höhe des Verschlussprofils zusammen der Höhe des Grundkörpers.

Um einen guten Sitz des Verschlussprofils im Grundkörper zu ermöglichen, begrenzt erfindungsgemäß ein Paar von seitlichen Kantenstreifen einen Fußstreifen des Profilstreifens; zwischen zwei benachbarten Fußstreifen verläuft der Bodenbereich einer Einformung bzw. eines Zwischenraumes des Grundkörpers, dieser Bodenbereich soll einen teilkreisförmig gekrümmten Querschnitt aufweisen.

Bei einer besonders günstigen Ausgestaltung ist das Verschlussprofil mit in Längsrichtung verlaufenden Profillippen versehen, die seine Rinne zur Aufnahme der Profilstreifen des Grundkörpers beidseits begrenzen. Zudem sollen endwärtige Lippenränder der Profillippen in Verbundlage jeweils den Kantenstreifen der Profilstreifen aufsitzen.

Eine weitere Ausgestaltung des erfindungsgemäßen Kühlkörpers zeichnet sich dadurch aus, dass an dessen Grundkörper zwischen seinen Randstreifen und zu diesen in Abstand zumindest ein Mittelsteg angeformt ist, an den beidseits jeweils eine Einformung des Grundkörpers zur Aufnahme eines Verschlussprofils anschließt; dieser Grundkörper bietet also den Einsatz von zwei oder mehr Verschlussprofilen an. Dabei ragen von einer Bodenplatte der Einformung mehrere Profilstreifen parallel zueinander auf, wobei auf dem Bodenbereich der beidseits von den Profilstreifen verlaufenden Einformungen zwei Bodenwülste verlaufen, die mit den beiden seitlichen Profilstreifen drei Bodenrinnen begrenzen. Zudem sollen von der Bodenfläche des Verschlussprofils Längsnuten zur Aufnahme der freien Enden der Profilstreifen des Grundkörpers in Verbundlage ausgehen sowie zwischen die Mündungen der Längsnuten in die Bodenfläche des Verschlussprofils Längsrinnen eingeformt sein.

Als günstig hat es sich erwiesen, dass Grundkörper und Verschlussprofil in Verbundlage Hohlkammern begrenzen, die jeweils zwischen zwei in Abstand parallelen Randbegrenzungen querschnittlich in ihrem Firstbereich zwei Längsrinnen sowie in ihrem Bodenbereich zwei jenen gegenüberliegende Bodenwülste aufweisen. Die Längskanten des Grundkörpers sollen jeweils von einem Randstreifen einer Höhe gebildet sein, welch letztere die Höhe des Kühlkörpers bestimmt.

Ein erfindungsgemäßes Verfahren zum Herstellen eines Kühlkörpers durch Strangpressen eines Grundkörpers aus einer Aluminiumlegierung mit von diesem aufragenden Profilstreifen zwischen nutartigen Einformungen, zeichnet sich dadurch aus, dass zumindest ein plattenartiges Verschlussprofil mit Aufnahmenuten für die Profilstreifen des Grundkörpers aus einer Aluminiumlegierung stranggepresst und als Verschlusspartner mit dem Grundkörper etwa parallel so durch Druck verbunden wird, dass zwischen den Verschlusspartnern kanalartige Hohlräume hergestellt werden. Letztere dienen im Rahmen der Erfindung zum Führen eines Fluids zur Wärmeabfuhr. Letzteres kann gasförmig oder eine Flüssigkeit sein.

Der erfindungsgemäße Kühlkörper wird also aus zumindest zwei Strangpressprofilen zusammengesetzt, wobei durch das Fügen der erfindungsgemäßen Bauform die kanalartigen Hohlkammern entstehen. Zur Erzeugung dichter Strömungskanäle werden Schweißen, Reibschweißen, Löten und dgl. Verfahren eingesetzt.

Zum Verbinden des Grundkörpers mit dem/den Verschlussprofil/en -- zwischen denen im Bereich der gegenseitigen Berührungsflächen fallweise Dichtungen oder Dichtmassen angebracht sein können -- mögen die Elemente beispielsweise gegenseitig verpresst werden. Das Verschlussprofil kann in den Grundkörper eingepresst werden, dies fallweise unter Verformung der Zahnprofile, an den sich berührenden Kanten. Das Verschlussprofil kann auch eingesetzt und durch Verkleben, Verclinchen, Einrasten durch Rastnasen, Schweißen wie Laserschweißen, Schutzgasschweißen etc., durch Einrollen oder Bördeln, festgelegt werden.

Die Hohlräume, d.h. die Oberflächen an Grundkörper und Verschlussprofil, welche die Hohlräume begrenzen, können mit Schutzschichten, wie anodischen Schichten, Schutzlacken, Plattierungen, physikalisch oder chemisch abgeschiedene Dünnschichten aus Metallen oder Metall- oder Halbmetallverbindungen und/oder Kunststoffbelägen bedeckt sein.

Durch die getrennte Herstellung der oben beschriebenen Profile als sogenannte Vollprofile sind komplizierte Oberflächengeometrien möglich, welche den Wärmeeintrag aus dem Profil in das durchströmende Fluid deutlich zu erhöhen vermögen. Durch eine besondere Gestaltung der formgebenden Kontur am Strangpresswerkzeug wird eine Wellung von einem oder mehreren Stegen in Längsrichtung erreicht. Diese in der Hohlkammer liegende Geometrie erzeugt Verwirbelung im durchströmenden Fluid, was eine verbesserte Wärmeabfuhrleistung zur Folge hat.

Ein weiterer Fortschritt bei der getrennten Fertigung des Kühlplattensystems liegt in der vereinfachten Weiterbearbeitung der Innenkontur zum Einbringen von Umlenkungen oder Sammlern, die üblicherweise bei von Fluid durchströmten Systemen notwendig sind.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in:
- Fig. 1:: die Frontansicht eines Kühlkörpers nach dem Stande der Technik mit von einem Gehäusesockel aufragenden Kühlrippen;
- Fig. 2:: einen vergrößerten Teil des Gehäusesockels der Fig. 1;
- Fig. 3, 4:: jeweils einen vergrößerten Ausschnitt aus Fig. 1 zu zwei unterschiedlichen Ausgestaltungen des Gehäusesockels sowie der Kühlrippen, wobei in Fig. 4 ein weitergehend vergrößerter Teilbereich skizziert ist;
- Fig. 5:: die Draufsicht auf eine Grundplatte eines erfindungsgemäßen Kühlkörpers;
- Fig. 6:: eine Stirnansicht der Grundplatte nach Fig. 5;
- Fig. 7, 8:: jeweils eine Stirnansicht einer anderen Grundplatte sowie eines dieser zuzuordnenden Verschlussprofils;
- Fig. 9:: einen Abschnitt von Grundplatte und Verschlussprofil während deren Zusammenbaues;
- Fig. 10,11:: die Stirnansichten einer anders gestalteten Grundplatte sowie ihres Verschlussprofils;
- Fig. 12:: einen Schnitt durch die Kühlplatteneinheit mit strömungsoptimierter Innenkontur aus Grundplatte und Verschlussprofil nach deren Zusammenbau;
- Fig. 13:: eine gegenüber Fig. 12 vergrößerte Kontur eines Kanals der Kühlplatteneinheit;
- Fig. 14:: eine Kühlplatteneinheit aus einer Grundplatte und zwei Verschlussprofilen in einer weiteren Ausgestaltung;
- Fig. 15:: ein vergrößertes Detail aus Fig. 14 mit der Grundplatte in Abstand zugeordnetem Verschlussprofil;
- Fig. 16:: eine gegenüber Fig. 13, 14 vergrößerte Kontur eines Kanals der Kühlplatteneinheit.

Ein Kühlkörper 10 für Halbleiterbauelemente weist ein in der Zeichnung aus Gründen der Übersichtlichkeit nicht weiter dargestelltes Gehäuse mit einer Sockelplatte als Gehäusesockel 12 einer beispielsweisen Breite a von etwa 202 mm und einer Dicke b von hier etwa 23,5 mm auf.

In die Sockelplatte 12 sind -- hier sechsunddreißig -- parallel zueinander verlaufende Einsatznuten 14 etwa rechteckigen Querschnitts einer Breite c von etwa 1,7 mm und einer Tiefe f von etwa 4 mm eingeformt, die durch Längs- oder Zwischenrippen 16 ebenfalls rechteckigen Querschnitts einer -- gegenüber den Einsatz- oder Bodennuten 14 etwas größeren -- Breite g von etwa 3,8 mm voneinander getrennt sind. Der Mittenabstand e zweier Einsatznuten 14 misst hier etwa 5,5 mm. In die Firstfläche jeder Zwischenrippe 16 ist eine querschnittlich V-artige Zwischennut 18 von oben her eingeformt.

In den Einsatznuten 14 sind in einem lichten Abstand z zueinander parallel verlaufende Kühlrippen 20 einer Breite i von 1,5 mm festgelegt. Gehäusesockel bzw. Sockelplatte 12 und Kühlrippen 20 werden getrennt auf dem Wege des Strangpressens aus Metall -- insbesondere aus Aluminiumlegierungen -- hergestellt und anschließend zusammengefügt.

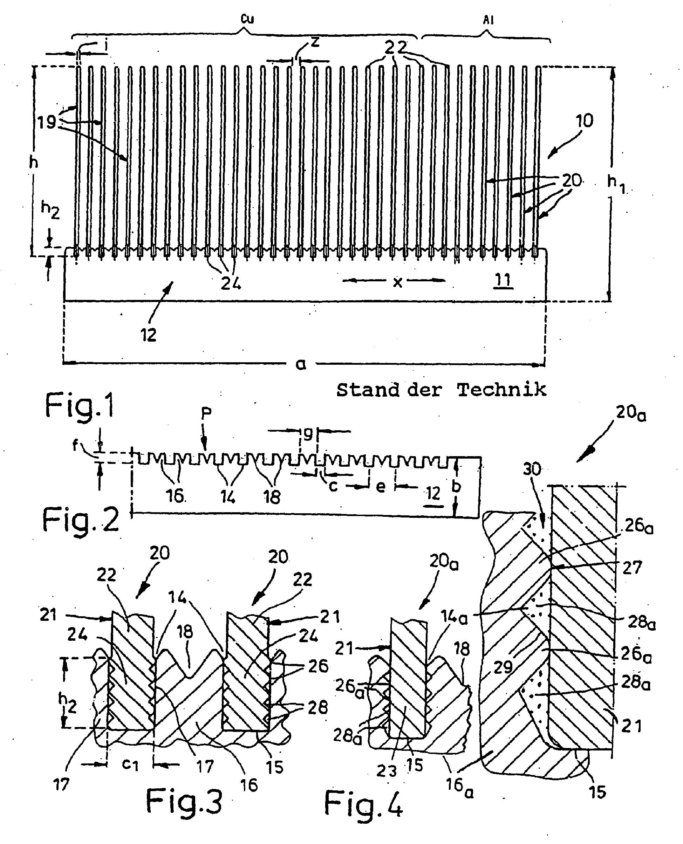

In Fig. 1 ist in deren Firstbereich angedeutet, dass nur ein Teil der Kühlrippen 20 aus Leichtmetall gefertigt sind, ein anderer Teil enthält Kühlrippen aus einem Material mit hohem Wärmeleitwert, insbesondere Kupferwerkstoff oder Graphit, die der besseren Übersicht halber mit 19 gekennzeichnet sind. Das Gewicht des Kühlkörpers 10 der Fig. 1 setzt sich aus dem Sockelgewicht von 11,884 kg/m sowie dem Rippengehalt von 0,328 kg/m zusammen, beträgt also 23,692 kg/m .

Da im Falle der unterschiedlichen Metalle bei den Rippen 19, 20 unterschiedliche Ausdehnungskoeffizienten entstehen, werden die Kühlrippen 20, 40 in ihrer Längsersteckung unterteilt, beispielsweise durch ein in Pfeilrichtung x der Fig. 1 geführtes -- nicht gezeigtes -- Sägeblatt, das in Abstand zur Längsseite 11 des Gehäusesockels 12 durch die Kühlrippen 19, 20 geführt wird.

Es hat sich gezeigt, dass sich eine Kühlleistung des Kühlkörpers auch dadurch verbessern lässt, dass Mittel zur Erzeugung eines gewissen Turbulenzanteils bei der die Rippen durchsetzenden Luftströmung an einer Kühlrippe des Kühlkörpers vorgesehen sind. Zweckmäßigerweise kann eine Kühlrippe dazu eine oder mehrere Ausnehmungen aufweisen. Eine solche Ausnehmung lässt sich z.B. als ein mittiges eingestanztes Längsloch an der Kühlrippe bilden. Weiter ist es auch möglich eine Kühlrippe z. B. entlang ihrer Länge, durch zumindest einen Einschnitt zu unterbrechen.

Die Kühlrippe 20 der Länge h von etwa 81 mm -- die eine Gesamthöhe h₁ des Kühlkörpers 10 von 100,5 mm vorgibt -- besteht in Fig. 1, 3 aus einem in Einbaulage frei aufragenden -- zwei ebene Seitenflächen 21 anbietenden -- plattenartigen Rippenkörper 22 sowie einem angeformten Kupplungssockel 24 der Höhe h₂ von 4 mm, dessen Querschnitt etwa jenem der Einsatznuten 14 entspricht; in Fig. 3 ist die Sockelbreite mit c₁ gekennzeichnet. In die beiden freien Seitenflächen des Kupplungssockels 24 jeder Kühlrippe 20 sind hier -- durch zur Sockeloberfläche parallele Rippen 26 getrennte -- Längseinformungen 28 so eingeformt, dass die Rippen 26 der einen Seitenfläche den Rippen 26 der anderen Seitenfläche-- und damit auch die Längseinformungen 28 in den Seitenflächen -- gegenüberstehen.

Der Kupplungssockel 24 wird in die Einsatznut 14 der Sockelplatte 12 eingeschoben, bis er dem Nutentiefsten 15 aufsitzt. Zur besseren Lagesicherung zwischen den ebenen Nutwänden 17 benachbarter Zwischenrippen 16 ist -- wie Fig. 3 zeigt -- jede Flankenfläche des Kupplungssockels 24 mit querschnittlich eine sägezahnartige Anordnung ergebenden Rippen 26 sowie Längseinformungen 28 versehen.

Nach dem Einsetzen des Kupplungssockels 24 in die Einsatznut 14 wird der Zwischennut 18 der Zwischenrippe 16 ein hier nicht dargestelltes plattenähnliches -- in Pfeilrichtung P der Fig. 2 druckbelastetes -- Fügewerkzeug zugeführt, dessen jener Zwischennut 18 zugekehrter Bodenrand mit einer zinnenartigen Reihe von Zähnen ausgestattet sein kann und in die Zwischennut 18 eingesetzt wird.

Bei der Ausgestaltung nach Fig. 4 ist die Kühlrippe 20ₐ ohne besondere Ausbildung eines Kupplungssockels am freien Rippenende 23 in die Einsatznut 14ₐ bis zum Nutentiefstens 15 eingeschoben, deren Seitenflächen 17ₐ Längseinformungen 28ₐ zwischen Rippen 26ₐ aufweisen. Die Zahnspitzen oder Endgrate 27 der Rippen 26ₐ liegen den glatten Seitenflächen 21 der Kühlrippe 20ₐ an.

Die Einsatznuten 14ₐ bzw. der Kupplungssockel 24 werden also querschnittlich etwa sägezahnförmig gestaltet und die stranggepresste Sockelplatte 12 zwischen den Einsatznuten 14, 14ₐ zusätzlich mit den V-förmigen Zwischennuten 18 ausgestattet. Letztere dienen dabei zur Führung des beschriebenen Fügewerkzeuges. Vor dem Einbringen in die Einsatznuten 14, 14ₐ werden die Kupplungssockel 24 oder die freien Rippenenden 23 mit einem Kunstharz 30 niedriger Viskosität benetzt. Letzteres weist zwei Komponenten auf: Härter und Binder, und es kann mit Partikeln aus Kupfer oder anderem Halbedelmetall gemischt sein. Dabei lässt sich im Hinblick auf die Anwendung und die für die Verarbeitung zweckmäßige Viskosität unter anderem das Mischungsverhältnis beider Komponenten einstellen. Insbesondere wird das Gemisch aus weiter unten genannten Gründen vorzugsweise mit Partikeln aus hochwärmeleitfähigem Material, wie Graphit oder einem Halbedelmetall, z. B. Kupfer versetzt.

Nach oder während dem Einlegen der Kühlrippen 20, z.B. durch Einrammen derselben, werden die Flanken der Zwischennuten 18 so verformt, dass das Kunstharz 30 aufgrund geringer Viskosität im Bereich der Zahnspitzen 27 völlig verdrängt wird, so dass dort ein metallischer Kontakt gegeben ist (wie in Fig. 4 auf deren rechten Seite angedeutet). Dadurch soll gewährleistet werden, dass die auf diese Weise entstandenen Kontaktbahnen durch das Kunstharz 30 derart gegen aggressive Medien abgeschirmt sind, dass eine Korrosionsgefahr weitgehend ausgeschlossen werden kann. Um zusätzlich einen verbesserten Wärmeübergang zu erreichen, sind in das Kunstharz metallische Partikel mit hohem Wärmeleitwert eingelagert. Schwerkraftbedingt werden diese Partikel noch vor dem Aushärten im Kunstharz 30 geringer Viskosität in den Längseinformungen oder Zahnlücken 28 zur unteren Wandfläche 29 absinken und damit zu Bahnen mit hohem metallischem Anteil sowie noch weiter verbesserter Wärmeleitfähigkeit führen.

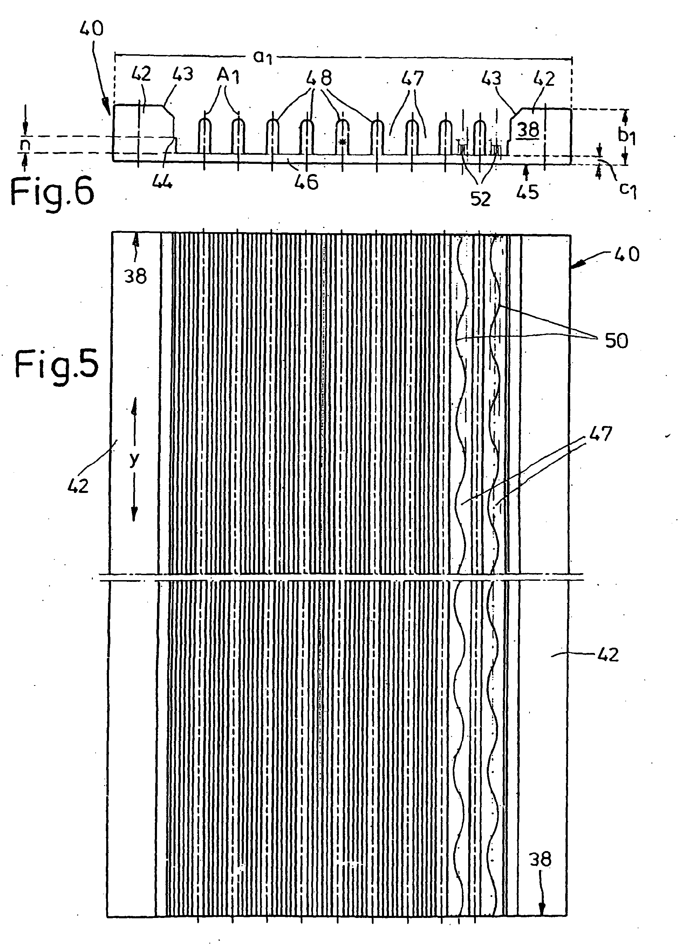

Ein erfindungsgemäßer stranggepresster Grundkörper 40 einer Breite a₁ von 160 mm für eine Kühlplatteneinheit bzw. einen Kühlkörper wird gemäß Fig. 5, 6 durch eine besondere Gestaltung der formgebenden Kontur eines nicht wiedergegebenen Strangpresswerkzeuges hergestellt. Von einer -- beidseits von kantenwärts parallel angeformten Randstreifen 42 der Höhe b₁ von 20 mm, die jeweils eine einwärts geneigte Kantenschräge 43 sowie eine innere Stufung 44 der Höhe n von 6 mm aufweisen, begleiteten -- mit einer ebenen Unterfläche 45 versehenen Bodenplatte 46 der Dicke c₁ von 3 mm des Grundkörpers 40 ragen neun angeformte, Zwischenräume 47 begrenzende Profilstreifen 48 rechteckigen Querschnittes der Höhe n₃ zinnenartig auf, die sich parallel zueinander zwischen den Stirnkanten 38 der Grundplatte 40 erstrecken. In diesen verläuft jeweils eine der Wellungen 50, die von einem Steg 52 -- oder mehreren Stegen 52 -- in Längsrichtung erreicht wird; dargestellt ist in zwei dem rechten Randstreifen 42 benachbarten Einformungen oder Zwischenräumen 47 jeweils eine Wellung 50. Diese in der Hohlkammer liegende Geometrie erzeugt eine zwangsweise Änderung des Strömungsverhaltens, wie eine Strömungsbeschleunigung oder eine Umschichtung bis hin zu einer Verwirbelung im durchströmenden Fluid, was eine verbesserte Wärmeabfuhrleistung zur Folge hat. Damit können z.B. Kavitationen durch das strömende Medium vermieden werden oder es kann ein inniger Wärmetransport durch die Dicke des Kühlkörpers hindurch erreicht werden.

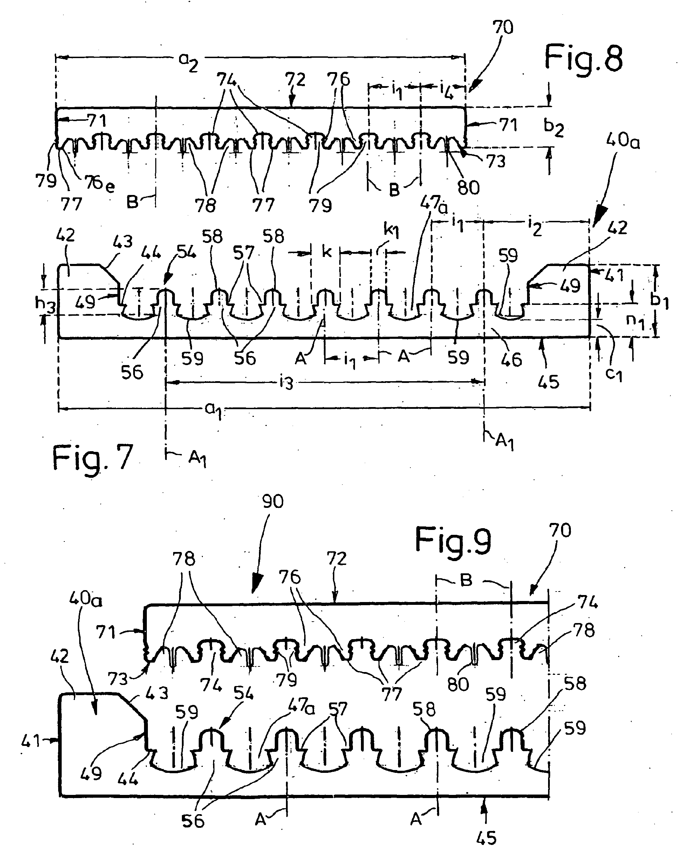

Die Breite a₁ des Grundkörpers 40ₐ der Fig. 7 beträgt 140 mm bei einer Höhe b₁ des Randstreifens 42 von 20 mm. Die Höhe n₁ der Stufung 44 über der Unterfläche 45 der Bodenplatte 46 misst 9 mm. Jeder der hier sieben Profilstreifen 54 weist oberhalb eines Fußstreifens 56 der Breite k einen angeformten Profil- oder Kammstreifen 58 der Breite k₁ auf; letzterer misst hier 4 mm und entspricht der Hälfte jener Breite k. Beidseits des Kammstreifens 58 ist ein Kantenstreifen 57 des Fußstreifens 56 zu erkennen. Der Bodenbereich 59 des jeweiligen Zwischenraumes 47 ist rinnenartig gekrümmt, also querschnittlich teilkreisförmig.

Der mittige Abstand i₁ zweier Profilstreifen 54 -- also von deren Profilachsen A voneinander -- beträgt 14 mm, der Abstand i₂ des randnahen Profilstreifens 54 zur Seitenfläche 41 des Randstreifens 42 misst hier 28 mm und der Abstand i₃ zwischen den randnächsten beiden Längsachsen A₁ dazu 84 mm.

In Fig. 8 ist ein ebenfalls durch Strangpressen hergestelltes Verschlussprofil 70 der Breite a₂ von 108 mm sowie der Höhe b₂ von 11 mm skizziert, das gemäß Fig. 9 auf die Kühlplatte bzw. den Grundkörper 40ₐ aufgesetzt wird. Die Oberfläche 72 dieses Verschlussprofils 70 ist eben, in die mit 73 gekennzeichnete Boden- oder Unterfläche sind in mittigem Abstand i₁ sieben Rinnen 74 eingeformt, deren Querschnitt die Aufnahme eines zugeordneten Kopfstreifens 58 des Profilstreifens 54 ermöglicht; die Querschnittsachse B der Rinne 74 fluchtet beim Zusammenbau mit der Achse A bzw. A₁ des zugeordneten Kopfstreifens 58. Der Abstand i₄ der Querschnittsachse B der randnächsten Rinne 74 von der Seitenfläche 71 des Verschlussprofils beträgt 12 mm.

Die beiden Flanken jeder Rinne 74 des Verschlussprofils 70 werden von -- parallel zu den Randstreifen 42 verlaufenden -- Profilrippen 76 gebildet, deren jeweiliger Lippenrand 77 beim Zusammenbau einem Kantenstreifen 57 des Grundkörpers 40ₐ aufgelegt wird. Diese an ihrer rinnenseitigen Fläche mit in Längsrichtung (y in Fig. 5) parallel angformten Zahnstreifen ausgestattete Profillippe 76 begrenzt anderseits eine Mulde 78 teilkreisförmigen Querschnittes, in deren Muldenmitte ein Profilstreifen 80 angeformt ist, welcher parallel zu jenen Querschnittsachsen B die beidseitigen Profillippen 76 überragt.

Beim Zusammenbau eines Kühlkörpers 90 aus dem Grundkörper 40ₐ und dem Verschlussprofil 70 gleitet dessen Seitenfläche 71 an der Innenfläche 49 des Randstreifens 42 abwärts, bis der Lippenrand 77 der einen Teil der Seitenfläche 71 bildenden Profillippe 76ₑ der Stufung 44 des Randstreifens 42 aufsitzt. Die auch hier seitlich an die Profillippe 76 nahe deren Lippenrand 77 angeformte Zahnung 79 schmiegt sich haltend an die beschriebenen Innenfläche 49 des Randstreifens 42 an.

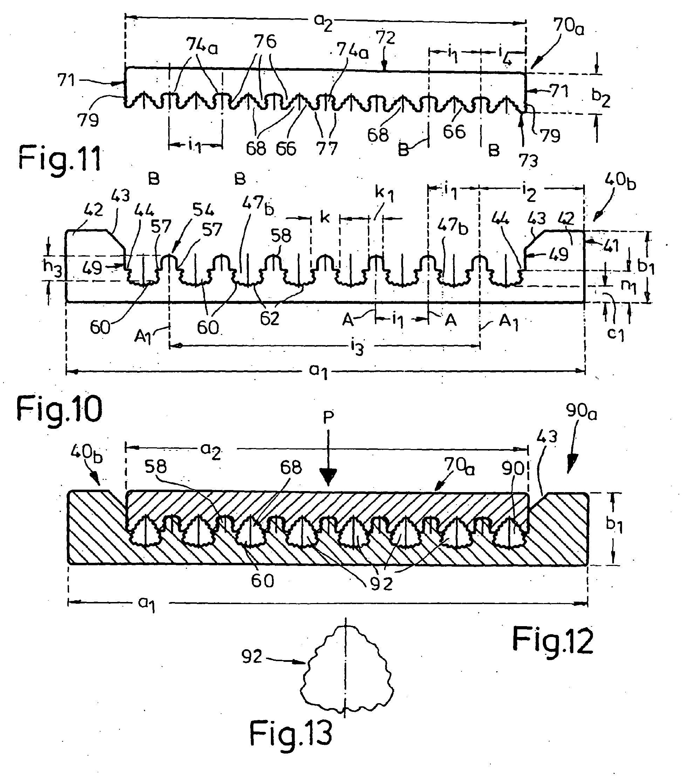

Wie insbesondere zu Fig. 12 beschrieben, erfolgt beim Zusammenbau durch den Druck P eines Fügewerkzeuges ein Pressvorgang, der in Längsrichtung verlaufende Hohlkammern oder Kanäle 92 entstehen lässt (s. Fig. 10, 13).

Der Grundkörper 40_{b} der Fig. 10 sowie das Verschlussprofil 70ₐ der Fig. 11 sind in der oben beschriebenen Weise gestaltet mit dem Unterschied, dass die Bodenbereiche 60 zwischen den Profilstreifen 54 mit einer Zahnung 62 in Längsrichtung y ausgestattet sind. Zudem verlaufen neben den Rinnen 74ₐ des Verschlussprofils 70ₐ querschnittlich dreiecksförmige Mulden 68, deren Wandflächen Zahnungen 66 in Längsrichtung y anbieten. Die Kontur der beim Zusammenbau von Grundkörper 40_{b} und Verschlussprofil 70ₐ gemäß Fig. 12 zu einem Kühlkörper 90ₐ entstehenden Kanäle bzw. Hohlkammern 92 ist in Fig. 13 hervorgehoben, die vor allem die durch ihre wellenartige Gestaltung vergrößerte Oberfläche der Hohlkammerwandung deutlich werden lässt.

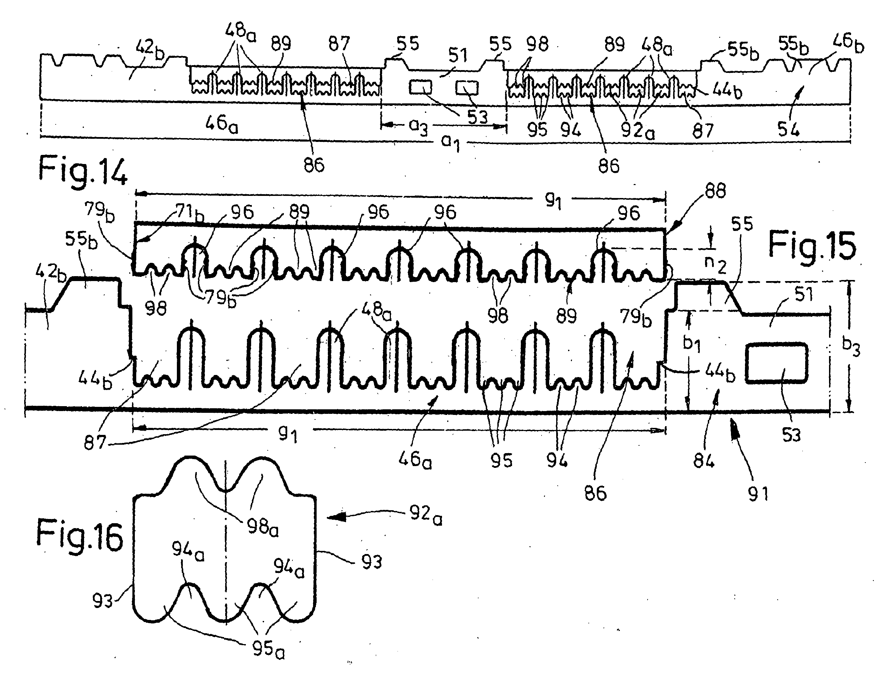

Die Fig. 14, 15 stellen einen Kühlkörper 91 als Einheit aus einem Grundkörper 84 -- der Breite a₁ von 463 mm und der Höhe b₃ von 26 mm mit zwei -- von sieben Profilstreifen oder Stiften 48 unterbrochenen -- jeweils einer Streifennut ähnliche Einformungen 86 der Breite g₁ von etwa 105 mm und zwei diese ergänzenden Verschlussprofilen 88 geringfügig kürzerer Breite g₂ vor. Die jene Einformung 86 nach unten begrenzende Bodenplatte 46ₐ, die beidends in jeweils einen Randstreifen 42_{b} übergeht sowie mittig einen Mittelsteg 51 der Breite a₃ aufweist, ist zwischen jeweils zwei von ihr rechtwinkelig aufragenden, in Längsrichtung y verlaufenden Profilstreifen 48ₐ mit zwei zu diesen parallelen -- und in den Zwischenraum 87 aufragenden -- Bodenwulsten 94 ausgestattet, die drei schmale Bodenrinnen 95 begrenzen. Jener Mittelsteg 51 weist zwei Längskanäle 53 sowie an jedem Stegrand einen Firststreifen 55 auf. Von jedem der Randstreifen 42_{b} ragen vier Firststreifen 55_{b} auf; ohne diese umfasst die Höhe b₁ die Dicke der beiden Teile 84/88 in Verschlussstellung.

Fig. 15 verdeutlicht, dass die zu Fig. 8 beschriebenen Zahnstreifen auch hier bei 79_{b} an den Innenflächen der Nuten 94 verlaufen sowie an der Seitenfläche 71_{b} des Verschlussprofils 88; dieser ist eine Stufung 44_{b} des Randstreifens 42_{b} zugeordnet.

In der gezeigten Verbindungsstellung greift die Spitze von jedem der sieben Profilstreifen 48ₐ in eine Nut 96 des Verschlussprofils 88 ein, dessen Bodenfläche 89 zwischen den Nuten 96 der Höhe n₂ zwei Längsrinnen 98 aufweist. Die Kontur der dadurch bestimmten Hohlkammer 92ₐ ist in Fig. 16 skizziert mit zwei -- durch die Profilstreifen 48ₐ erzeugten -- parallelen Randbegrenzungen 93, den Konturen 95ₐ der drei Bodenrinnen 95 zwischen den Konturen 94ₐ zweier Bodenwülste 94 sowie Konturen 98ₐ zweier Längs- oder Kopfrinnen 98.

Beispielhaft werden nachfolgend einige Querschnittswerte zur Hohlkammer 92ₐ angegeben:

| | |
|---|---|
| Querschnittsfläche: | 45,39 mm²; |
| Dichte: | 2,7 kg/dm³; |
| Laufmetergewicht: | 0,123 kg/m; |
| Länge Außenkontur: | 31,04 mm; |
| Länge Innenkontur: | 0,0 mm. |

Diesen werden entsprechende Querschnittswerte des Grundkörpers 84 und des Verschlussprofils 88 gegenübergestellt.

| Grundkörper: | |
|---|---|
| Querschnittsfläche: | 1,461,58 mm²; |
| Dichte: | 2,7 kg/dm³; |
| Laufmetergewicht: | 3,946 kg/m; |
| Länge Außenkontur: | 468,87 mm; |
| Länge Innenkontur: | 0,0 mm. |

| Verschlussprofil: | |
|---|---|
| Querschnittsfläche: | 939,66 mm²; |
| Dichte: | 2,7 kg/dm³; |
| Laufmetergewicht: | 2,537 kg/m; |
| Länge Außenkontur: | 349,3 mm; |
| Länge Innenkontur: | 0,0 mm. |

Ein besonderer Fortschritt durch die getrennte Fertigung des Kühlplattensystems liegt in der vereinfachten Weiterbearbeitung der Innenkontur zum Einbringen von Umlenkungen oder Sammlern, die bei von einem Fluid durchströmten Systemen notwendig sind; die beschriebenen kanalartigen Hohlkammern 92,92ₐ können vor allem gasartige Fluide sowie Flüssigkeiten aufnehmen und leiten.

Die gasartigen Fluide und insbesondere die Flüssigkeiten können in den Hohlräumen stehen bzw. können die Hohlräume laminar oder turbulent durchströmen. Zu den Flüssigkeiten gehören beispielsweise Wasser, organische Flüssigkeiten wie Alkohole - beispielsweise Methanol, Ethanol, Glykole usw. oder Gemische von organischen Flüssigkeiten mit Wasser, dies gegebenenfalls unter Zusatz von Korrosionsinhibitoren. Andere Flüssigkeiten sind Solen, Öle, öl- und wasserhaltige Emulsionen, verflüssigte Metalle oder Metalllegierungen. Ferner können fallweise Gase oder verflüssigte Gase, wie Kohlenwasserstoffe, chlorierte und/oder fluorierte Kohlenwasserstoffe, CO₂, Stickstoff etc. als Fluide verwendet werden. Die Gase, resp. Flüssigkeiten, können in den Hohlräumen kondensieren resp. verdampfen oder können unter Wärmetransport, wie Wärmeab- oder -zuführung die Hohlkammer durchströmen. Unbewegte Fluide können die Isolation, die Temperaturregulierung oder die Temperaturverteilung innerhalb des Kühlplattensystems beeinflussen.

Abschließend sei darauf hingewiesen, dass die in der Beschreibung angegebenen Maßzahlen beispielhaft sind und den Bedürfnissen entsprechend variiert werden können.

## Patentansprüche

1. Kühlkörper für Halbleiterbauelemente oder dergleichen Wärmequellen mit in Abstand zueinander von einem stranggepressten Grundkörper (40, 40ₐ, 40_{b}, 84) aufragenden Profilstreifen (48, 48ₐ, 58), denen jeweils eine nutartige Einformung (47, 47ₐ, 87) benachbart ist, wobei dem plattenartigen Grundkörper wenigstens ein Verschlussprofil (70, 70ₐ, 88) zugeordnet ist, das an seiner Boden- oder Unterfläche (73, 89) Rinnen (74, 74ₐ, 96) zur Aufnahme jeweils eines Profilstreifens des Grundkörpers aufweist sowie in Verbundlage oder -stellung den Grundkörper als Basisteil überspannt,
**dadurch gekennzeichnet,**
**dass** zwischen den Rinnen des Verschlussprofils (70, 70ₐ, 88) jeweils zumindest eine weitere Einformung (68, 78) vorgesehen ist, wobei der Einformung des Verschlussprofils in Verbundlage zumindest eine nutartige Einformung (47, 47ₐ, 87) des aus einer Aluminiumlegierung bestehenden Grundkörpers (40, 40ₐ, 40_{b}, 84) angrenzend gegenüberliegt und mit ihr den Querschnitt einer kanalartigen Hohlkammer (92, 92ₐ) bestimmt.

2. Kühlkörper nach Anspruch 1, **dadurch gekennzeichnet, dass** in Verbundlage des Grundkörpers (40, 40ₐ, 40_{b}, 84) mit dem dessen Oberfläche aufliegenden plattenartigen Verschlussprofil (70, 70ₐ, 88) mehrere kanalartige Hohlkammern (92, 92ₐ) oder Einformungen etwa parallel zueinander in Längsrichtung (y) zwischen den Stirnkanten (38) des Grundkörpers verlaufen.

3. Kühlkörper nach Anspruch 1 oder 2, **dadurch gekennzeichnet, dass** die kanalartige Einformung (68, 78) des Verschlussprofils (70, 70ₐ) von i. w. dreiecksförmigem Querschnitt ist.

4. Kühlkörper nach einem der Ansprüche 1 bis 3, **dadurch gekennzeichnet, dass** die Wandung der kanalartigen Hohlkammer (92) und/oder die Innenflächen der Einformung (68, 78) mit einer querschnittlichen Zahnung versehen ist/sind.

5. Kühlkörper nach Anspruch 4, **dadurch gekennzeichnet, dass** die Einformung (78) des Verschlussprofils (70) in Querschnittsmitte einen Profilstreifen (80) enthält und diese Profilstreifen des Verschlussprofils in dessen Längsrichtung parallel zueinander und zu den Seitenflächen (71) des Verschlussprofils verlaufen.

6. Kühlkörper nach einem der Ansprüche 1 bis 5, **dadurch gekennzeichnet, dass** von den seitlichen Innenflächen der Rinnen (74, 74ₐ) des Verschlussprofils (70, 70ₐ) zumindest ein Zahnstreifen (79) abragt, wobei die Zahnstreifen der einen Innenfläche der Rinne (74, 74ₐ) i. w. rechteckigen Querschnitts den Zahnstreifen der anderen Innenfläche bevorzugt gegenüberliegen.

7. Kühlkörper nach einem der Ansprüche 1 bis 6, **dadurch gekennzeichnet, dass** in dem Zwischenraum (47) zwischen zwei Profilstreifen (48) zumindest ein Steg (52) des Grundkörpers (40) verläuft, der zum Erzeugen einer Wellung (50) im Grundkörper (40, 40ₐ, 40_{b}, 84) oder im Verschlussprofil (70, 70ₐ, 88) ausgebildet ist.

8. Kühlkörper nach einem der Ansprüche 1 bis 7, **dadurch gekennzeichnet, dass** der Grundkörper (40, 40ₐ, 40_{b}, 84) an seinen Längsseiten jeweils mit einem Randstreifen (42) versehen ist, der die Oberfläche der Bodenplatten (46, 46ₐ) und die davon aufragenden Profilstreifen (48) überragt.

9. Kühlkörper nach Anspruch 8, **dadurch gekennzeichnet, dass** der Randstreifen (42) an seiner Innenfläche (49) in Abstand zur Bodenplatte (46, 46ₐ) des Grundkörpers (40, 40ₐ, 40_{b}, 84) parallel zu dieser in Längsrichtung (y) eine Stufung (44) als Anschlagelement für das Verschlussprofil (70, 70ₐ, 88) aufweist.

10. Kühlkörper nach wenigstens einem der Ansprüche 1 bis 9, **dadurch gekennzeichnet, dass** der Profilstreifen (54) des Grundkörpers (40ₐ, 40_{b}) beidseits mit einem stufenartig vorstehenden Kantenstreifen (57) als Anschlagelement für das Verschlussprofil (70, 70ₐ) versehen ist.

11. Kühlkörper nach Anspruch 9 und 10, **dadurch gekennzeichnet, dass** die Stufungen (44) der Randstreifen (42) des Grundkörpers (40ₐ, 40_{b}) eine gemeinsame Ebene für die Kantenstreifen (57) der Profilstreifen (54) bestimmen.

12. Kühlkörper nach einem der Ansprüche 9 bis 11, **dadurch gekennzeichnet, dass** der Abstand (n₁) der Stufung (44) von der Unterfläche (45) der Bodenplatte (46, 46ₐ) und die Höhe (b₂) des Verschlussprofils (70, 70ₐ, 88) zusammen der Höhe (b₁) des Grundkörpers (40ₐ, 40_{b} , 84) etwa entsprechen.

13. Kühlkörper nach Anspruch 10 oder 11, **dadurch gekennzeichnet, dass** ein Paar von seitlichen Kantenstreifen (57) einen Fußstreifen (56) des Profilstreifens (54) begrenzt und zwischen zwei benachbarten Fußstreifen der Bodenbereich (59) einer Einformung bzw. eines Zwischenraumes (47ₐ, 47_{b}) des Grundkörpers (40ₐ, 40_{b}) verläuft.

14. Kühlkörper nach wenigstens einem der Ansprüche 1 bis 13, **dadurch gekennzeichnet, dass** das Verschlussprofil (70, 70ₐ) in Längsrichtung (y) verlaufende Profillippen (76) aufweist, die seine Rinne (74) zur Aufnahme der Profilstreifen (59) des Grundkörpers (40, 40ₐ) beidseits begrenzen.

15. Kühlkörper nach Anspruch 10 und 14, **dadurch gekennzeichnet, dass** endwärtige Lippenränder (77) der Profillippen (76) in Verbundlage jeweils den Kantenstreifen (57) der Profilstreifen (94) aufsitzen.

16. Kühlkörper nach wenigstens einem der Ansprüche 1 bis 15, **dadurch gekennzeichnet, dass** an den Grundkörper (84) des Kühlkörpers (91) zwischen seinen Randstreifen (42_{b}) und zu diesen in Abstand (g₁) zumindest ein Mittelsteg (51) abgeformt ist, an den beidseits jeweils eine Einformung (86) des Grundkörpers zur Aufnahme eines Verschlussprofils (88) anschließt,

17. Kühlkörper nach Anspruch 16, **dadurch gekennzeichnet, dass** ein Mittelsteg (51) sowie zwei anschließende Einformungen (86) des Grundkörpers (84) vorgesehen sind, welch letztere andernends von einem der Randstreifen (42_{b}) begrenzt sind.

18. Kühlkörper nach Anspruch 16 oder 17, **dadurch gekennzeichnet, dass** von einer Bodenplatte (46ₐ) der Einformung (86) mehrere Profilstreifen (48ₐ) parallel zueinander aufragen, wobei vom Bodenbereich der beidseits von den Profilstreifen verlaufenden Einformungen zwei Bodenwülste (94) aufragen, die mit den beiden seitlichen Profilstreifen drei Bodenrinnen (95) begrenzen.

19. Kühlkörper nach einem der Ansprüche 16 bis 18, **dadurch gekennzeichnet, dass** von der Bodenfläche (89) des Verschlussprofils (88) Längsnuten (96) zur Aufnahme der freien Enden der Profilstreifen (48ₐ) des Grundkörpers (84) in Verbundlage ausgehen.

20. Kühlkörper nach Anspruch 19, **dadurch gekennzeichnet, dass** zwischen die Mündungen der Längsnuten (96) in die Bodenfläche (89) des Verschlussprofils (88) Längsrinnen (98) eingeformt sind.

21. Kühlkörper nach einem der Ansprüche 16 bis 20, **dadurch gekennzeichnet, dass** Grundkörper (84) und Verschlussprofil (88) in Verbundlage Hohlkammern (92ₐ) begrenzen, die jeweils zwischen zwei in Abstand parallelen Randbegrenzungen (93) querschnittlich in ihrem Firstbereich zwei Längsrinnen (98ₐ) sowie in ihrem Bodenbereich zwei jenen gegenüberliegende Bodenwülste (94ₐ) aufweisen.

22. Kühlkörper nach einem der Ansprüche 1 bis 21, **dadurch gekennzeichnet, dass** die Längskanten des Grundkörpers (40, 40ₐ, 40_{b}, 84) jeweils von einem Randstreifen (42) einer Höhe (b₁) gebildet sind, welch letztere die Höhe des Kühlkörpers (90, 98ₐ, 91) bestimmt.

23. Verfahren zum Herstellen eines Kühlkörper durch Strangpressen eines Grundkörpers mit von diesem aufragenden Profilstreifen zwischen nutartigen Einformungen und zumindest ein plattenartiges Verschlussprofil mit Rinnennuten, nach einem der vorhergehenden Ansprüche, **dadurch gekennzeichnet, dass** die Rinnennuten als Aufnahmenuten für die Profilstreifen des Grundkörpers aus einer Aluminiumlegierung stranggepresst werden und das Verschlussprofil als Verschlusspartner mit dem Grundkörper etwa parallel so durch Druck verbunden wird, dass zwischen den Verschlusspartnern kanalartige Hohlräume hergestellt werden.

## Claims

1. Cooling unit for semiconductor components or similar heat sources comprising profile strips (48, 48ₐ, 58) which project, at a distance from one another, from an extruded base element (40, 40ₐ, 40_{b}, 84) and each of which has a groove-like moulding (47, 47ₐ, 87) adjacent thereto, at least one locking profile (70, 70ₐ, 88) being assigned to the plate-like base element, which profile comprises channels (74, 74ₐ, 96), on the base or lower surface (73, 89) thereof, in each case for receiving a profile strip of the base element and extends across the base element as a base component in the connected state or position, **characterised in that** at least one further moulding (68, 78) is provided between the channels of the locking profile (70, 70ₐ, 88) in each case, at least one groove-like moulding (47, 47ₐ, 87) of the base element (40, 40ₐ, 40_{b}, 84), which consists of an aluminium alloy, lying opposite and adjacent to the moulding of the locking profile in the connected state and determining together with said moulding the cross-section of a channel-like hollow chamber (92, 92ₐ).

2. Cooling unit according to claim 1, **characterised in that** in the connected state of the base element (40, 40ₐ, 40_{b}, 84), with the plate-like locking profile (70, 70ₐ, 80) lying against the surface thereof, a plurality of channel-like hollow chambers (92, 92ₐ) or mouldings extend approximately parallel to one another in the longitudinal direction (y) between the end edges (38) of the base element.

3. Cooling unit according to either claim 1 or claim 2, **characterised in that** the channel-like moulding (68, 78) of the locking profile (70, 70ₐ) has a substantially triangular cross-section.

4. Cooling unit according to any one of claims 1 to 3, **characterised in that** the wall of the channel-like hollow chamber (92) and/or the inner surfaces of the moulding (68, 78) is/are provided with a cross-sectional toothing.

5. Cooling unit according to claim 4, **characterised in that** the moulding (78) of the locking profile (70) contains a profile strip (80) in the centre of the cross-section thereof, and these profile strips of the locking profile extend in the longitudinal direction of said profile parallel to one another and to the lateral faces (71) of the locking profile.

6. Cooling unit according to any one of claims 1 to 5, **characterised in that** at least one toothed strip (79) projects from the lateral inner faces of the channels (74, 74ₐ) of the locking profile (70, 70ₐ), the toothed strips of one inner face of the channel (74, 74ₐ), which has a substantially rectangular cross-section, lying opposite the toothed strips of the other inner face.

7. Cooling unit according to any one of claims 1 to 6, **characterised in that** at least one web (52) of the base element (40) extends in the intermediate space (47) between two profile strips (48) and is formed so as to create a wave shape (50) in the base element (40, 40ₐ, 40_{b}, 84) or in the locking profile (70, 70ₐ, 88).

8. Cooling unit according to any one of claims 1 to 7, **characterised in that** the base element (40, 40ₐ, 40_{b}, 84) is provided on each of the longitudinal sides thereof with an edge strip (42), which projects over the surface of the base plates (46, 46ₐ) and the profile strips (48) projecting therefrom.

9. Cooling unit according to claim 8, **characterised in that** the edge strip (42) comprises, on the inner surface (49) thereof at a distance from the base plate (46, 46ₐ) of the base element (40, 40ₐ, 40_{b}, 84), a step (44), parallel to said plate in the longitudinal direction (y), as a stop element for the locking profile (70, 70ₐ, 88).

10. Cooling unit according to at least one of claims 1 to 9, **characterised in that** the profile strip (54) of the base element (40ₐ, 40_{b}) is provided on both sides with an edge strip (57) protruding in a step-like manner as a stop element for the locking profile (70, 70ₐ).

11. Cooling unit according to claim 9 and claim 10, **characterised in that** the steps (44) of the edge strip (42) of the base element (40ₐ, 40_{b}) determine a common plane for the edge strips (57) of the profile strips (54).

12. Cooling unit according to any one of claims 9 to 11, **characterised in that** the distance (n₁) of the step (44) from the lower face (45) of the base plate (46, 46ₐ) and the height (b₂) of the locking profile (70, 70ₐ, 88) together approximately correspond to the height (b₁) of the base element (40ₐ, 40_{b}, 84).

13. Cooling unit according to either claim 10 or claim 11, **characterised in that** a pair of lateral edge strips (57) delimits a foot strip (56) of the profile strip (54) and extends between two adjacent foot strips of the base region (59) of a moulding or of an intermediate space (47ₐ, 47_{b}) of the base element (40ₐ, 40_{b}).

14. Cooling unit according to at least one of claims 1 to 13, **characterised in that** the locking profile (70, 70ₐ) comprises profile lips (76) extending in the longitudinal direction (y), which delimit on both sides the channel (74) of said locking profile for receiving the profile strips (59) of the base element (40, 40ₐ).

15. Cooling unit according to claim 10 and claim 14, **characterised in that** in the connected state, endward lip edges (77) of the profile lips (76) in each case rest on the edge strips (57) of the profile strips (94).

16. Cooling unit according to at least one of claims 1 to 15, **characterised in that** a central web (51) is integrally moulded onto the base element (84) of the cooling units (91), between the edge strips (42_{b}) thereof and at a distance (g₁) therefrom, a moulding (86) of the base element for receiving a locking profile (88) adjoining said web on either side.

17. Cooling unit according to claim 16, **characterised in that** a central web (51) and two adjacent mouldings (86) of the base element (84) are provided, said mouldings being delimited at the other end by one of the edge strips (42_{b}).

18. Cooling unit according to either claim 16 or claim 17, **characterised in that** a plurality of profile strips (48ₐ) project parallel to one another from a base plate (46ₐ) of the moulding (86), two base elevations (94) projecting from the base region of the mouldings which extend on both sides of the profile strip and, together with the two lateral profile strips, delimiting three base channels (95).

19. Cooling unit according to any one of claims 16 to 18, **characterised in that** in the connected state, longitudinal grooves (96) for receiving the free ends of the profile strips (48ₐ) of the base element (84) extend from the base surface (89) of the locking profile (88).

20. Cooling unit according to claim 19, **characterised in that** longitudinal channels (98) are moulded between the openings of the longitudinal grooves (96) into the base surface (89) of the locking profile (88).

21. Cooling unit according to any one of claims 16 to 20, **characterised in that** in the connected state, the base element (84) and locking profile (88) delimit hollow chambers (92ₐ) which in each case comprise, between two spaced parallel edge boundaries (93), two longitudinal channels (98ₐ) in the apex region of the cross-section and two base elevations (94ₐ) opposite these in the base region.

22. Cooling unit according to any one of claims 1 to 21, **characterised in that** the longitudinal edges of the base element (40, 40ₐ, 40_{b}, 84) are in each case formed by an edge strip (42) of a height (b₁) which ultimately determines the height of the cooling unit (90, 98ₐ, 91).

23. Method for manufacturing a cooling unit by extruding a base element, comprising profile strips projecting therefrom between two groove-like mouldings, and at least one plate-like locking profile with channel grooves, according to any one of the preceding claims, **characterised in that** the channel grooves are extruded from an aluminium alloy as grooves for receiving the profile strips of the base element, and the locking profile is connected by pressure to the base element as a locking partner in an approximately parallel manner, in such a way that channel-like hollow spaces are produced between the locking partners.

## Revendications

1. Corps de refroidissement pour composants semi-conducteurs ou sources de chaleur analogues, avec des bandes profilées (48, 48ₐ, 58) saillantes à distance l'une de l'autre sur un corps de base extrudé (40, 40ₐ, 40_{b}, 84), à proximité desquelles il se trouve chaque fois un enfoncement en forme de rainure (47, 47ₐ, 87), dans lequel au moins un profilé de fermeture (70, 70ₐ, 88) est associé au corps de base en forme de plaque, profilé qui présente sur sa face de fond ou face inférieure (73, 89) des gorges (74, 74ₐ, 96) destinées à recevoir chacune une bande profilée du corps de base et qui recouvre, en une position ou placement composite, le corps de base constituant une pièce de base, **caractérisé en ce qu'**il est prévu chaque fois au moins un autre enfoncement (68, 78) entre les gorges du profilé de fermeture (70, 70ₐ, 88), dans lequel au moins un enfoncement en forme de rainure (47, 47ₐ, 87) du corps de base (40, 40ₐ, 40_{b}, 84) constitué d'un alliage d'aluminium fait face à l'enfoncement du profilé de fermeture en position composite et détermine avec lui la section transversale d'une chambre creuse (92, 92ₐ) en forme de canal.

2. Corps de refroidissement selon la revendication 1, **caractérisé en ce que**, dans la position composite du corps de base (40, 40ₐ, 40_{b}, 84) avec le profilé de fermeture en forme de plaque (70, 70ₐ, 88) appliqué sur sa surface, plusieurs chambres creuses (92, 92ₐ) ou plusieurs enfoncements en forme de canal s'étendent sensiblement parallèlement l'un à l'autre dans la direction longitudinale (y) entre les côtés frontaux (38) du corps de base.

3. Corps de refroidissement selon la revendication 1 ou 2, **caractérisé en ce que** l'enfoncement en forme de canal (68, 78) du profilé de fermeture (70, 70ₐ) présente une section transversale essentiellement triangulaire.

4. Corps de refroidissement selon l'une quelconque des revendications 1 à 3, **caractérisé en ce que** la paroi de la chambre creuse en forme de canal (92) et/ou les faces intérieures de l'enfoncement (68, 78) est/sont dotée(s) d'une section transversale dentelée.

5. Corps de refroidissement selon la revendication 4, **caractérisé en ce que** l'enfoncement (78) du profilé de fermeture (70) comprend une bande profilée (80) au milieu de sa section transversale et ces bandes profilées du profilé de fermeture s'étendent parallèlement l'une à l'autre et aux faces latérales (71) du profilé de fermeture dans la direction longitudinale de celui-ci.

6. Corps de refroidissement selon l'une quelconque des revendications 1 à 5, **caractérisé en ce qu'**au moins une bande dentelée (79) part des faces intérieures latérales des gorges (74, 74ₐ) du profil de fermeture (70, 70ₐ), dans lequel les bandes dentelées d'une première face intérieure de la gorge (74, 74ₐ), de section transversale essentiellement rectangulaire, font de préférence face aux bandes dentelées de l'autre face intérieure.

7. Corps de refroidissement selon l'une quelconque des revendications 1 à 6, **caractérisé en ce que**, dans l'espace intermédiaire (47) compris entre deux bandes profilées (48), il se trouve au moins une nervure (52) du corps de base (40), qui est réalisée de façon à produire une ondulation (50) dans le corps de base (40, 40ₐ, 40_{b}, 84) ou dans le profilé de fermeture (70, 70ₐ, 88).

8. Corps de refroidissement selon l'une quelconque des revendications 1 à 7, **caractérisé en ce que** le corps de base (40, 40ₐ, 40_{b}, 84) est pourvu, sur chaque côté longitudinal, d'une bande de bord (42) qui couvre la surface des plaques de fond (46, 46ₐ) et les bandes profilées (48) saillantes sur celles-ci.

9. Corps de refroidissement selon la revendication 8, **caractérisé en ce que** la bande de bord (42) présente, sur sa face intérieure (49) à distance de la plaque de fond (46, 46ₐ) du corps de base (40, 40ₐ, 40_{b}, 84) et parallèlement à celle-ci dans la direction longitudinale (y), un gradin (44) formant élément de butée pour le profilé de fermeture (70, 70ₐ, 88).

10. Corps de refroidissement selon l'une quelconque des revendications 1 à 9, **caractérisé en ce que** la bande profilée (54) du corps de base (40ₐ, 40_{b}) est pourvue, de part et d'autre, d'une bande de côté saillante en forme de gradin (57) formant élément de butée pour le profilé de fermeture (70, 70ₐ).

11. Corps de refroidissement selon l'une quelconque des revendications 9 et 10, **caractérisé en ce que** les gradins (44) des bandes de bord (42) du corps de base (40ₐ, 40_{b}) déterminent un plan commun pour les bandes de côté (57) des bandes profilées (54).

12. Corps de refroidissement selon l'une quelconque des revendications 9 à 11, **caractérisé en ce que** la distance (n₁) du gradin (44) par rapport à la face inférieure (45) de la plaque de fond (46, 46ₐ) et la hauteur (b₂) du profilé de fermeture (70, 70ₐ, 88) correspondent ensemble sensiblement à la hauteur (b₁) du corps de base (40ₐ, 40_{b}, 84).

13. Corps de refroidissement selon l'une quelconque des revendications 10 ou 11, **caractérisé en ce qu'**une paire de bandes de côté latérales (57) limite une bande de pied (56) de la bande profilée (54) et la zone de fond (59) d'un enfoncement ou d'un espace intermédiaire (47ₐ, 47_{b}) du corps de base (40ₐ, 40_{b}) s'étend entre deux bandes de pied voisines.

14. Corps de refroidissement selon au moins une des revendications 1 à 13, **caractérisé en ce que** le profilé de fermeture (70, 70ₐ) présente des lèvres profilées (76) s'étendant en direction longitudinale (y) et limitant de part et d'autre sa gorge (74) destinée à recevoir les bandes profilées (59) du corps de base (40, 40ₐ).

15. Corps de refroidissement selon les revendications 10 et 14, **caractérisé en ce que** des bords de lèvre extrêmes (77) des lèvres profilées (76) reposent en position composite chaque fois sur les bandes de côté (57) des bandes profilées (94).

16. Corps de refroidissement selon l'une quelconque des revendications 1 à 15, **caractérisé en ce qu'**au moins une nervure centrale (51) est formée sur le corps de base (84) du corps de refroidissement (91), entre ses bandes de bord (42_{b}) et à une distance (g₁) de celles-ci, nervure à laquelle se raccorde respectivement de part et d'autre un enfoncement (86) du corps de base destiné à recevoir un profilé de fermeture (88).

17. Corps de refroidissement selon la revendication 16, **caractérisé en ce qu'**il est prévu une nervure centrale (51) ainsi que deux enfoncements (86) du corps de base (84) qui s'y raccordent, ces derniers étant limités à l'autre extrémité par une des bandes de bord (42_{b}).

18. Corps de refroidissement selon la revendication 16 ou 17, **caractérisé en ce que** plusieurs bandes profilées (48ₐ) parallèles l'une à l'autre sont saillantes sur une plaque de fond (46ₐ) de l'enfoncement (86), dans lequel deux bourrelets de fond (94) sont saillants sur la zone de fond des enfoncements s'étendant de part et d'autre des bandes profilées, lesquels limitent trois gorges de fond (95) avec les deux bandes profilées latérales.

19. Corps de refroidissement selon l'une quelconque des revendications 16 à 18, **caractérisé en ce que** des rainures longitudinales (96) destinées à recevoir les extrémités libres des bandes profilées (48ₐ) du corps de base (84) en position composite partent de la face de fond (89) du profilé de fermeture (88).

20. Corps de refroidissement selon la revendication 19, **caractérisé en ce que** des gorges longitudinales (98) sont formées entre les débouchés des rainures longitudinales (96) dans la face de fond (89) du profilé de fermeture (88).

21. Corps de refroidissement selon l'une quelconque des revendications 16 à 20, **caractérisé en ce que** le corps de base (84) et le profilé de fermeture (88) limitent en position composite des chambres creuses (92ₐ), qui présentent chaque fois, en section transversale, entre deux flancs parallèles espacés (93), dans la région de leur faîte deux gorges longitudinales (98ₐ) ainsi que dans la région de leur fond deux bourrelets de fond (94ₐ) opposés à celles-ci.

22. Corps de refroidissement selon l'une quelconque des revendications 1 à 21, **caractérisé en ce que** les côtés longitudinaux du corps de base (40, 40ₐ, 40_{b}, 84) sont formés chaque fois par une bande de bord (42) d'une hauteur (b₁), qui détermine la hauteur du corps de refroidissement (90, 98ₐ, 91).

23. Procédé de fabrication d'un corps de refroidissement par extrusion d'un corps de base avec des bandes profilées saillantes sur celui-ci entre des enfoncements en forme de rainures et au moins un profilé de fermeture en forme de plaque avec des gorges, selon l'une quelconque des revendications précédentes, **caractérisé en ce que** les gorges en forme de rainures destinées à recevoir les bandes profilées du corps de base sont extrudées à partir d'un alliage d'aluminium et le profilé de fermeture, formant partenaire de fermeture, est assemblé par pression au corps de base, en position sensiblement parallèle, de façon à créer des espaces creux en forme de canaux entre les deux partenaires de fermeture.
